# EUROPÄISCHE PATENTANMELDUNG

(11) **EP 3 573 110 A1**
(43) Veröffentlichungstag der Anmeldung: **27.11.2019**
(21) Anmeldenummer: 18174444.2
(22) Anmeldetag: 25.05.2018
(51) Int. Cl.: H01L 31/02

(54) **SOLARMODUL MIT VERGRÖSSERTER APERTURFLÄCHE**

(71) Anmelder: (CNBM) Bengbu Design & Research Institute for Glass Industry Co., Ltd., 233010 Bengbu (CN)
(72) Erfinder: Palm, Jörg, 80797 München (DE); Kalio, René, 04357 Leipzig (DE)
(74) Vertreter: Gebauer, Dieter Edmund

(57) **Zusammenfassung**

Die Erfindung betrifft ein Solarmodul, mit einem flächigen Substrat und einer Mehrzahl Solarzellen, die zwischen zwei Leiterbahnen in Reihe verbunden und auf einer ersten Seite des Substrats angeordnet sind, wobei die Solarzellen einen optisch aktiven Modul-Innenbereich bilden, der von einem optisch inaktiven Modul-Randbereich umgeben ist, wobei jeder Leiterbahn ein Loch im Substrat, eine Anschlußdose auf einer zweiten Seite des Substrats, eine elektrische Verbindung zwischen einer Abgreifstelle an der Leiterbahn und einer Anschlußstelle der Anschlußdose zugeordnet sind, wobei das Loch wenigstens teilweise im Modul-Innenbereich positioniert ist, derart, daß sich die Abgreifstelle an der Leiterbahn außerhalb einer fluchtenden Verlängerung des Lochs befindet und mindestens eine Solarzelle unterteilt ist der eine verkürzte Länge aufweist.

## Beschreibung

Die vorliegende Erfindung liegt auf dem technischen Gebiet der photovoltaischen Energieerzeugung und betrifft ein Solarmodul mit einer Aperturfläche, die im Vergleich zur Aperturfläche von herkömmlichen Solarmodulen mit gleichen Abmessungen vergrößert ist.

Die Gestehungskosten für Strom aus Photovoltaik hängen von verschiedenen Beiträgen ab. Neben den Herstellungskosten der Komponenten des Gesamtsystems gehen Eigenschaften des Solarmoduls, wie Leistung, Temperaturkoeffizient und Schwachlichtverhalten ein. Darüber hinaus ist die Lebensdauer der Komponenten und des Gesamtsystems eine wesentliche Einflußgröße. Da die Gestehungskosten letztlich entscheidend für den wirtschaftlichen Erfolg einer photovoltaischen Anlage sind und den Wettbewerb mit anderen Energieformen, wie Windenergie, fossile Brennstoffe oder Kernenergie maßgeblich beeinflussen, müssen bei der Entwicklung der Solarmodule, neben den Kosten und der Leistung, auch die Zuverlässigkeit und Lebensdauer optimiert werden. In der Praxis hat sich gezeigt, daß für eine zufriedenstellende Erfüllung der Anforderungen an Kosten, Leistung und Lebensdauer oftmals Kompromisse gefunden werden müssen, da sich die erforderlichen Maßnahmen häufig gegensätzlich auf diese Anforderungen auswirken.

Grundsätzlich ist bei Solarmodulen die optisch aktive Nutzfläche (Aperturfläche) kleiner als die äußeren Abmessungen des Solarmoduls, da der Randbereich durch eine Randversiegelung gegen Feuchte geschützt werden muß und somit nicht zur photovoltaischen Energieerzeugung genutzt werden kann. Zudem muß die Isolationstrecke zwischen Innen und Außen des Solarmoduls groß genug sein, um alle technischen Normen und Zertifizierungsprüfungen zu bestehen. Hinzu kommt der Flächenbedarf für die Kontaktierung der serienverschalteten Solarmodule. Bei einem Dünnschichtsolarmodul mit monolithischer Serienverschaltung der Solarzellen wird die elektrische Leistung von zwei an den beiden Längsseiten des Moduls angeordneten Stromsammelleitern (Busbars), die typischer Weise in Form von Kontaktbändern ausgebildet sind, abgegriffen. Für einen elektrischen Außenkontakt des Solarmoduls sind typischer Weise zwei Anschlußdosen auf der Rückseite des Moduls vorgesehen, wobei gemäß einer gängigen Bauweise die Kontaktbänder durch zwei Löcher im Substratglas, die in Überdeckung zu den Kontaktbändern positioniert sind, kontaktiert werden.

Um die Aperturfläche möglichst groß zu machen, muß der optisch inaktive Randbereich möglichst schmal sein. Dennoch muß die Randversiegelung ausreichend breit sein, um das Innere des Solarmoduls langfristig gegen vom Rand her eindringende Feuchte zu schützen. Zudem ist zu berücksichtigen, daß die Kontaktbänder mit einer Verschmälerung des Randbereichs weiter nach außen gerückt werden und damit auch die in Überdeckung zu den Kontaktbändern positionierten Löcher im Substratglas zur Kontaktierung der Leiterbahnen mit den Anschlußdosen. Wenn die Löcher jedoch näher an den Modulrand rücken, erhöht sich in erheblichem Maße das Risiko für Glasbruch bei der Herstellung oder bei mechanischer Belastung durch Wind- und Schneelasten in der praktischen Anwendung.

Bekannt sind auch Solarmodule, bei denen die beiden Kontaktbänder jeweils am seitlichen Modulrand entlang zu einem Loch im Substratglas geführt, hindurch gefädelt und in einer gemeinsamen Anschlußdose kontaktiert werden. Nachteilig bei dieser Vorgehensweise ist der relativ große Platzbedarf für die beiden Kontaktbänder am Modulrand, wodurch die optisch aktive Nutzfläche erheblich vermindert wird. Zudem ist der Herstellungsprozeß relativ komplex. Erschwerend kommt hinzu, daß je nach Montageart (mit Rahmen oder rahmenlos, mit Rückseitenschiene oder Klammern) an der kurzen Modulseite auch höhere mechanische Spannungen auftreten können, welche zu einem Bruch in der praktischen Anwendung führen können.

Weiterhin bekannt sind Solarmodule, bei denen die Kontaktbänder zwischen den beiden Substraten des Solarmoduls seitlich herausgeführt und auf dem rückseitigen Substrat zur Mitte hin zusammengeführt werden. Dies setzt jedoch voraus, daß die Kontaktbänder und die Austrittsbereiche ausreichend elektrisch isoliert und gegen Feuchte geschützt werden. Das wird in aller Regel durch eine Rückseitenfolie realisiert, die jedoch zusätzliche, relativ hohe Kosten verursacht.

Demgegenüber besteht die Aufgabe der vorliegenden Erfindung darin, im Stand der Technik bekannte Solarmodule in vorteilhafter Weise mit einer vergrößerten Aperturfläche zu versehen, ohne daß die eingangs geschilderten Nachteile auftreten. Zudem sollen die Solarmodule in der industriellen Serienfertigung mit gängigen Verfahren kostengünstig und effizient herstellbar sein.

Diese und weitere Aufgaben werden nach dem Vorschlag der Erfindung durch ein Solarmodul gemäß dem unabhängigen Patentanspruch gelöst. Vorteilhafte Ausgestaltungen der Erfindung sind durch die Merkmale der Unteransprüche angegeben.

Erfindungsgemäß ist ein Solarmodul mit elektrisch in Serie verschalteten Solarzellen zur photovoltaischen Energieerzeugung gezeigt. Grundsätzlich kann es sich bei dem erfindungsgemäßen Solarmodul um jede Art von Solarmodul handeln. Vorzugsweise handelt es sich um ein Dünnschichtsolarmodul mit in monolithisch integrierter Form serienverschalteten Solarzellen. Vorzugsweise weist das Dünnschichtsolarmodul eine Verbundscheibenstruktur auf, wobei ein rückseitiges Trägersubstrat und eine frontseitige Abdeckung (z.B. Glasplatten) durch eine thermoplastische oder elastomere Zwischenschicht (z.B. PVB-Schicht) fest miteinander verbunden sind. Vorzugsweise weist das Dünnschichtsolarmodul eine Substratkonfiguration auf, bei der der Schichtenaufbau zur Formung der Solarzellen auf einer der Lichteintrittsseite zugewandten Oberfläche eines rückseitigen Trägersubstrats aufgebracht ist. Das Trägersubstrat und die Abdeckung können beispielsweise aus Glas, Kunststoff, Metall oder einer Metalllegierung bestehen. Typischer Weise ist zumindest das Trägersubstrat als starre Platte ausgestaltet. Vorzugsweise besteht das Trägersubstrat aus Glas. Vorzugsweise besteht auch die Abdeckung aus Glas.

Der Schichtenaufbau des Dünnschichtsolarmoduls umfaßt in an sich bekannter Weise eine Rückelektrodenschicht, eine Frontelektrodenschicht, und eine zwischen Rück- und Frontelektrodenschicht angeordnete, optisch (photovoltaisch) aktive Absorberschicht. Die Frontelektrodenschicht ist optisch transparent, da ein Durchtritt von Licht zum Schichtenaufbau ermöglicht sein muß. Die Frontelektrodenschicht umfaßt oder besteht typischer Weise aus einem dotierten Metalloxid (TCO = Transparent Conductive Oxide), beispielsweise n-leitendes, insbesondere Aluminium-dotiertes, Zinkoxid (AZO). Vorzugsweise umfaßt oder besteht die Absorberschicht aus einem Chalkopyrit-Halbleiter, bei dem es sich vorteilhaft um einen ternären I-III-VI-Verbindungshalbleiter aus der Gruppe Kupfer-Indium/Gallium-Disulfid/Diselenid (Cu(In,Ga) (S,Se)₂) handelt. In vorstehender Formel können Indium und Gallium jeweils allein oder in Kombination vorliegen. Entsprechendes gilt für Schwefel und Selen, die jeweils allein oder in Kombination vorliegen können. Die Absorberschicht weist typischer Weise eine Dotierung von einem ersten Leitungstyp (d.h. Ladungsträgertyp) und die Frontelektrode eine Dotierung vom entgegengesetzten Leitungstyp auf. In aller Regel ist die Absorberschicht p-leitend (p-dotiert), verfügt also über einen Überschuß von Defektelektronen, und die Frontelektrodenschicht ist n-leitend (n-dotiert), so daß freie Elektronen in Überschuss vorhanden sind. Zwischen Absorber- und Frontelektrodenschicht ist typischer Weise eine Pufferschicht angeordnet. Dies gilt insbesondere für Absorberschichten auf Basis von Cu(In,Ga) (S,Se)₂, bei denen in aller Regel eine Pufferschicht zwischen einer p-leitenden Cu(In,Ga) (S,Se)₂-Absorberschicht und einer n-leitenden Frontelektrode benötigt wird. Die Pufferschicht ermöglicht eine elektronische Anpassung zwischen Absorber und Frontelektrode. Sie bietet außerdem einen Schutz vor Sputterschäden in einem nachfolgenden Prozeßschritt der Abscheidung der Frontelektrode beispielsweise durch DC-Magnetron-Sputtern. Durch die Abfolge aus n-leitender Frontelektrodenschicht, Pufferschicht und p-leitender Absorberschicht wird ein p-n-Heteroübergang gebildet, das heißt ein Übergang zwischen Schichten vom entgegengesetzten Leitungstyp. Die Absorberschicht kann beispielsweise auch aus Cadmiumtellerid (CdTe) bestehen. Die Rückelektrodenschicht ist typische Weise auf das Trägersubstrat abgeschieden. Die Rückelektrodenschicht umfaßt oder besteht typischer Weise aus Molybdän (Mo), wobei aber auch andere Metalle eingesetzt werden können.

Im Schichtenaufbau des Dünnschichtsolarmoduls sind durch Strukturierungslinien serienverschaltete Solarzellen ausgebildet. Hierbei ist (mindestens) die Rückelektrodenschicht durch erste Strukturierungslinien (P1-Linien) in Abschnitte unterteilt, welche die Rückelektroden der Solarzellen bilden. Ferner ist (mindestens) die Absorberschicht durch zweite Strukturierungslinien (P2-Linien) in Abschnitte unterteilt, welche die optisch aktiven Bereiche (Absorber) der Solarzellen bilden, und (mindestens) die Frontelektrodenschicht ist durch dritte Strukturierungslinien (P3-Linien) in Abschnitte unterteilt, welche die Frontelektroden der Solarzellen bilden. Benachbarte Solarzellen sind über elektrisch leitfähiges Material in den zweiten Strukturierungslinien in Serienverschaltung elektrisch miteinander verbunden, wobei die Frontelektrode einer Solarzelle mit der Rückelektrode der benachbarten Solarzelle elektrisch verbunden ist und mit dieser typischer Weise, jedoch nicht zwingend, direkten Berührungskontakt hat. Jede Strukturierungszone umfaßt eine unmittelbare Abfolge der drei Strukturierungslinien P1-P2-P3, jeweils in dieser Reihenfolge.

In Einklang mit der gängigen Verwendung bezieht sich der Begriff "Solarzelle" auf einen Bereich des Schichtenaufbaus, der eine Frontelektrode, einen Absorber und eine Rückelektrode aufweist und von zwei unmittelbar benachbarten Strukturierungszonen begrenzt wird. Im Randbereich des Moduls gilt dies analog, wobei anstelle einer Strukturierungszone ein Anschlußabschnitt für eine elektrische Kontaktierung der Serienverschaltung der Solarzellen vorhanden ist.

Das erfindungsgemäße Solarmodul umfaßt einen optisch (photovoltaisch) aktiven Innenbereich, der von den Solarzellen gebildet wird, und einen optisch (photovoltaisch) inaktiven Randbereich, der den Innenbereich (in der Modulebene) umgibt. Es versteht sich, daß der optisch aktive Innenbereich auch optisch inaktive Bereiche enthält, insbesondere die Strukturierungszonen mit den P1-/P2-/P3-Linien zur Formung der Solarzellen. Der Innenbereich entspricht der optisch aktiven Nutzfläche (Aperturfläche) des Solarmoduls. Typischer Weise weist der Innenbereich (Aperturfläche) entsprechend der Rechteckform der Solarzellen eine Rechteckform auf. In aller Regel ist der Schichtenaufbau im Randbereich innerhalb einer an den Modulrand angrenzenden Zone, welche gewöhnlich als "Randentschichtung" bezeichnet wird, vollständig entfernt oder nicht abgeschieden. Im Randbereich befinden sich darüber hinaus eine an den Modulrand angrenzende Randversiegelung sowie, weiter innen liegend, die beiden Stromsammelleiter (Busbars) bzw. Leiterbahnen zur elektrischen Kontaktierung der Solarzellen. Die Solarzellen sind in Serienverschaltung zwischen den beiden Leiterbahnen angeordnet. Die Leiterbahnen sind beispielsweise in Form von Kontaktbändern ausgebildet. Vorteilhaft erstreckt sich die Rückelektrodenschicht bis in den optisch inaktiven Randbereich hinein, wobei die beiden Leiterbahnen jeweils auf und in elektrischen Kontakt mit der Rückelektrodenschicht angeordnet sind, um den von den Solarzellen erzeugten Strom aufzunehmen.

In allgemeiner Weise umfaßt das erfindungsgemäße Solarmodul ein flächiges (Träger-)Substrat, vorzugsweise eine starre Glasplatte, sowie eine Mehrzahl Solarzellen, die zwischen einer ersten und zweiten Leiterbahn in Reihe verbunden und auf einer ersten Seite (Innenseite) des Substrats angeordnet sind. Vorzugsweise ist das Substrat eben und weist eine Rechteckform auf. Gleichermaßen weist das Solarmodul vorzugsweise eine Rechteckform auf. Vorzugsweise haben die Solarzellen jeweils eine Rechteckform. Vorzugsweise handelt es sich bei den beiden Leiterbahnen jeweils um Kontaktbänder. Vorzugsweise erstrecken sich die beiden Leiterbahnen jeweils entlang einer ersten Abmessung des Moduls bzw. Substrats, bei welcher es sich typischer Weise um die Länge des Solarmoduls handelt, während die Solarzellen entlang einer zweiten Abmessung angeordnet sind, bei welcher es sich typischer Weise um die (meist kürzer bemessene) Breite des Solarmoduls handelt. Typischer Weise ist die zweite Abmessung senkrecht zur ersten Abmessung gerichtet. Vorzugsweise sind die beiden Leiterbahnen jeweils mit der Rückelektrodenschicht elektrisch verbunden, insbesondere direkt auf der Rückelektrodenschicht angeordnet. Das Solarmodul umfaßt einen optisch aktiven (Modul-)Innenbereich, der sich aus den Solarzellen ergibt, und einen optisch inaktiven (Modul-)Randbereich, der den Innenbereich (in der Modulebene) umgibt (in Sicht senkrecht durch das Substrat). Typischer Weise weisen der Innenbereich und die vom Innenbereich gebildete Aperturfläche eine Rechteckform auf.

In dem erfindungsgemäßen Solarmodul sind den beiden Leiterbahnen jeweils (d.h. jeder Leiterbahn separat) zugeordnet:
- ein (Durchgangs-)Loch im Substrat,
- eine Anschlußdose auf einer zweiten Seite des Substrats,
- eine elektrische Verbindung zwischen einer Abgreifstelle an der Leiterbahn und einer Anschlußstelle der Anschlußdose.

Die beiden Anschlußdosen sind jeweils auf einer (außenseitigen) zweiten Seite des Substrats angeordnet. Typischer Weise überdeckt jede Anschlußdose das zugeordnete Loch im Substrat.

Im Sinne vorliegender Erfindung bezieht sich der Begriff "Abgreifstelle" auf die Stelle der jeweiligen Leiterbahn, an der der Strom von der Leiterbahn abgegriffen und der zugehörigen Anschlußstelle zugeleitet wird. An der Abgreifstelle wird der Strom in einer Richtung von der Leiterbahn abgeleitet, die von der Verlaufsrichtung der jeweiligen Leiterbahn verschieden ist, d.h. schräg bzw. quer zur Verlaufsrichtung der Leiterbahn.

Im erfindungsgemäßen Solarmodul sind die beiden Löcher im Substrat jeweils wenigstens teilweise, insbesondere vollständig, so im Innenbereich des Moduls positioniert, daß sich die zugeordnete Abgreifstelle an der Leiterbahn außerhalb einer fluchtenden Verlängerung des Lochs befindet. Somit befindet sich das Loch im Substrat nicht in Überlapp zur zugeordneten Abgreifstelle an der Leiterbahn, d.h. nicht über der Abgreifstelle. Vielmehr befindet sich die Abgreifstelle außerhalb eines Bereichs, der sich durch eine zum ebenen Substrat senkrechte Verlängerung des ersten Lochs ergibt. Die Abgreifstelle befindet sich somit auch nicht in direkter Sicht durch das zugeordnete Loch. Ferner sind die beiden Löcher jeweils soweit nach innen versetzt, daß wenigstens eine Solarzelle, insbesondere mehrere Solarzellen, jeweils in zwei Teil-Solarzellen unterteilt werden oder, bei randständiger Position des jeweiligen Lochs, (gegenüber den durch das Loch nicht beeinträchtigten Solarzellen) jeweils eine verkürzte Länge aufweisen. Zudem kann eine an eine vollständig unterteilte Solarzelle angrenzende, weitere Solarzelle angeschnitten sein. Bei Ausbildung der Löcher wird gleichzeitig die auf dem Substrat befindliche Rückelektrodenschicht entfernt, so daß der Schichtenbereich unterhalb der beiden Löcher grundsätzlich nicht mehr zur photovoltaischen Energieerzeugung genutzt werden kann.

Erfindungsgemäß wird somit die Position der beiden Löcher im Substrat von der Position der jeweils zugeordneten Abgreifstelle an der Leiterbahn räumlich getrennt. Dies ermöglicht in vorteilhafter Weise, daß die Leiterbahnen weiter an den Rand des Solarmoduls gelegt werden können, wobei zu beachten ist, daß das Solarmodul bei einer reduzierten Breite des optisch inaktiven Randbereichs weiterhin eine hinreichende Isolationsfestigkeit und Klimastabilität aufweisen soll. Zwar vermindert das Versetzen der beiden Löcher nach innen die optisch aktive Fläche des Solarmoduls (durch Unterteilen mindestens einer Solarzelle in zwei Teil-Solarzellen oder Verkürzen der Länge mindestens einer Solarzelle), jedoch kann die Aperturfläche durch eine Verschmälerung des Randbereichs insgesamt erheblich vergrößert werden. Auf diese Weise kann bei gegebener Modulgröße mehr Strom erzeugt werden und in vorteilhafter Weise reduzieren sich die Gestehungskosten des Stroms. Dies ist ein wichtiger Vorteil des erfindungsgemäßen Solarmoduls gegenüber herkömmlichen Solarmodulen, bei denen die Abgreifstellen der beiden Leiterbahnen jeweils in fluchtender Verlängerung eines zugeordneten Lochs im Substrat positioniert sind.

Bei einer vorteilhaften Ausgestaltung des erfindungsgemäßen Solarmoduls sind die beiden Löcher im Substrat jeweils soweit nach innen versetzt, daß sie einen Abstand von 1% bis 10%, insbesondere 5% bis 10%, des Abstands zwischen den beiden Leiterbahnen von der jeweils zugeordneten Leiterbahn haben. Hierdurch wird die optisch aktive Fläche der Solarzellen durch die Positionierung der beiden Löcher nur relativ geringfügig vermindert, wobei in Summe durch eine Verschmälerung des Randbereichs eine besonders gute Vergrößerung der Aperturfläche erreicht werden kann.

Vorteilhaft sind bei einem Dünnschichtsolarmodul mit einem auf dem Substrat aufgebrachten Schichtenaufbau die beiden Löcher im Substrat jeweils in bzw. über einer (Entschichtungs-) Zone des Schichtenaufbaus angeordnet (in der Modulebene in Sicht senkrecht durch das Modul), in der sämtliche Schichten mindestens bis zur Rückelektrodenschicht, insbesondere bis zur Rückelektrodenschicht, entfernt oder nicht aufgebracht sind. Vorzugsweise umfaßt die (Entschichtungs-)Zone einen Abschnitt, der in Form einer Einbuchtung des Innenbereichs ausgebildet ist. Die Positionierung der beiden Löcher im Innenbereich führt dann dazu, daß durch die jeweilige (Entschichtungs-)Zone mindestens eine Solarzelle, insbesondere mehrere Solarzellen, jeweils in zwei Teil-Solarzellen unterteilt werden oder, bei randständiger Position der (Entschichtungs-)Zone, jeweils eine verkürzte Länge aufweisen. Eine an eine unterteilte Solarzelle angrenzende Solarzelle kann angeschnitten sein.

Bei einer vorteilhaften Ausgestaltung des erfindungsgemäßen Solarmoduls weist die den beiden Löchern im Substrat jeweils zugeordnete elektrische Verbindung auf der ersten Seite des Substrats ein mit der zugeordneten Leiterbahn elektrisch verbundenes flächiges Kontaktelement auf, welches das zugeordnete Durchgangsloch wenigstens teilweise, insbesondere vollständig, überspannt. Die beiden flächigen Kontaktelemente sind beispielsweise in Form von Kontaktflecken (Pads) oder Kontaktstreifen ausgebildet. Das flächige Kontaktelement kann von der zugehörigen Leiterbahn verschieden sein, aber alternativ auch ein Teil der zugehörigen Leiterbahn sein (End- oder Zwischenabschnitt).

Die beiden flächigen Kontaktelemente sind jeweils mit der zugehörigen Leiterbahn elektrisch verbunden und ermöglichen eine besonders einfache Kontaktierung von außen mittels eines das zugeordnete Loch im Substrat durchsetzenden Kontaktstempels, um den von der jeweiligen Abgreifstelle abgeleiteten Strom der zugehörigen Anschlußdose zuzuführen. Dementsprechend wird gemäß einer bevorzugten Ausgestaltung des erfindungsgemäßen Solarmoduls das flächige Kontaktelement, welches das zugeordnete Loch im Substrat wenigstens teilweise, insbesondere vollständig, überspannt, von einem sich durch das Loch erstreckenden Kontaktstempel der zugeordneten Anschlußdose elektrisch kontaktiert. Die beiden Kontaktstempel sind jeweils Bestandteil der zugehörigen Anschlußdose und kontaktieren das jeweilige flächige Kontaktelement in direkter Sicht durch das Loch, d.h. in einem das Loch fluchtend verlängernden Bereich. Eine solche Anschlußdose kann beispielsweise der europäischen Patentanmeldung EP 12778258.9 entnommen werden, auf deren Inhalt in vollem Umfang Bezug genommen wird.

Gemäß einer Ausgestaltung des erfindungsgemäßen Solarmoduls liegt das flächige Kontaktelement einem mit der zugeordneten Leiterbahn elektrisch verbundenen Schichtabschnitt der Rückelektrodenschicht unmittelbar an. Wesentlich hierbei ist, daß der Schichtabschnitt zumindest im Innenbereich von den Solarzellen elektrisch isoliert ist, um einen Kurzschluß der Solarzellen zu vermeiden. Dies kann in einfacher Weise durch eine die Rückelektrodenschicht durchtrennende Trennlinie erfolgen, die den Schichtabschnitt zumindest im Innenbereich von einem übrigen Abschnitt der Rückelektrodenschicht elektrisch isoliert. Vorteilhaft erfolgt eine solche elektrische Isolierung des Schichtabschnitts von den Solarzellen auch im Randbereich, zu welchem Zweck sich beispielsweise die Trennlinie bis zur zugehörigen Leiterbahn erstreckt.

Die flächigen Kontaktelemente sind jeweils in Berührungskontakt mit der Rückelektrodenschicht angeordnet, d.h. liegen der Rückelektrodenschicht unmittelbar an. Vorzugsweise sind die beiden Kontaktelemente jeweils an der Rückelektrodenschicht befestigt, was bevorzugt durch Löten, Schweißen oder Kleben erfolgen kann. Diese Maßnahme ist insbesondere bei einer mechanischen Belastung des flächigen Kontaktelements bei einer Außenkontaktierung durch den Kontaktstempel der Anschlußdose vorteilhaft.

Gemäß einer ersten Variante vorstehender Ausgestaltung der Erfindung ist das flächige Kontaktelement von der zugehörigen Leiterbahn räumlich beabstandet, wobei eine elektrische Verbindung mit der Leiterbahn über den vom Kontaktelement elektrisch kontaktierten Schichtabschnitt der Rückelektrodenschicht erfolgt. Diese Variante hat den besonderen Vorteil, daß sich die Höhe des Schichtstapels im Bereich der Leiterbahn nicht erhöht. Zudem kann Material eingespart werden.

Gemäß einer zweiten Variante vorstehender Ausgestaltung der Erfindung ist das flächige Kontaktelement in Berührungskontakt, insbesondere in Überlapp, mit der zugeordneten Leiterbahn. Dies bedeutet, daß sich das flächige Kontaktelement bis zur zugehörigen Leiterbahn erstreckt. Vorteilhaft sind die beiden flächigen Kontaktelemente jeweils an der zugehörigen Leiterbahn beispielsweise durch Löten, Schweißen oder Kleben befestigt. Das flächige Kontaktelement kann wahlweise an der lichteintrittsseitigen Oberfläche oder der von der Lichteintrittsseite abgewandten Oberfläche der zugehörigen Leiterbahn befestigt sein.

Gemäß einer weiteren Ausgestaltung des erfindungsgemäßen Solarmoduls, bei der die beiden Leiterbahnen in Form von Kontaktbändern ausgebildet sind und sich jeweils entlang einer ersten Abmessung des Substrats erstrecken, wobei die Solarzellen entlang einer zweiten Abmessung angeordnet sind, umfaßt die elektrische Verbindung jeweils einen Endabschnitt oder einen Zwischenabschnitt der zugeordneten Leiterbahn, der von der Verlaufsrichtung entlang der ersten Abmessung abweicht und sich schräg oder quer zur ersten Abmessung erstreckt. Hierbei ist der End- oder Zwischenabschnitt durch das zugehörige Loch auf die zweite Seite des Substrats geführt und mit der Anschlußstelle der zugeordneten Anschlußdose elektrisch verbunden. In vorteilhafter Weise sind bei dieser Ausgestaltung der Erfindung keine separaten flächigen Kontaktelemente erforderlich und der Strom kann über den jeweiligen End- oder Zwischenabschnitt der in Form eines Kontaktbands ausgebildeten Leiterbahn abgeleitet werden. Ein Vorteil einer derartigen Ausgestaltung ist die Vermeidung einer relativ langen, an der Busbar angebrachten Kontaktfahne, die möglicherweise durch Polymerfluss während der Lamination aus ihrer Zielposition gedrückt werden könnte. Zudem besteht keine Gefahr, dass sich die Verbindung, insbesondere Schweißung, zwischen Kontaktfahne und Busbar löst.

Gemäß einer ersten Variante vorstehender Ausgestaltung des erfindungsgemäßen Solarmoduls liegt der End- oder Zwischenabschnitt der jeweiligen Leiterbahn einem mit der Leiterbahn elektrisch verbundenen Schichtabschnitt der Rückelektrodenschicht unmittelbar an, wobei der Schichtabschnitt zumindest im Innenbereich von den Solarzellen elektrisch isoliert ist, beispielsweise durch eine Trennlinie.

Gemäß einer zweiten Variante vorstehender Ausgestaltung des erfindungsgemäßen Solarmoduls sind sämtliche Schichten des Schichtenaufbaus im Bereich des End- oder Zwischenabschnitts der Leiterbahn entfernt oder nicht aufgebracht.

Gemäß einer weiteren Ausgestaltung des erfindungsgemäßen Solarmoduls weist der Abgreifpunkt von einem Ende der zugeordneten Leiterbahn einen Abstand auf, der 20% bis 50% einer Länge der Leiterbahn entspricht. Durch diese Maßnahme können in vorteilhafter Weise Ohm'sche Verluste in der Leiterbahn vermindert werden, da die durchschnittliche Länge des Strompfads entlang der Leiterbahn verkürzt wird. Dies ermöglicht in vorteilhafter Weise eine Verminderung der Querschnittfläche der Leiterbahn durch Verkleinern der Breite und/oder Dicke mit damit einher gehenden Vorteilen für die Einkapselung sowie, besonders vorteilhaft, einer weiteren Vergrößerung der optisch aktiven Fläche (Aperturfläche).

In dem erfindungsgemäßen Solarmodul ist durch die Positionierung der beiden Löcher im Substrat jeweils mindestens eine Solarzelle in zwei Teil-Solarzellen unterteilt oder weist eine verkürzte Länge auf. Besonders vorteilhaft sind die Solarzellen so ausgebildet, daß sie eine gleichgroße optisch aktive Fläche haben. Insbesondere haben zu diesem Zweck jene Solarzellen, die durch die Positionierung der beiden Löcher im Substrat in zwei Teil-Solarzellen unterteilt sind oder eine verkürzte Länge aufweisen jeweils eine größere Breite (Abmessung in Richtung der Serienverschaltung der Solarzellen) als die übrigen Solarzellen. Durch diese Maßnahme kann in vorteilhafter Weise erreicht werden, daß alle Solarzellen in einem zumindest annähernd gleichen Arbeitspunkt ihrer Kennlinie betrieben werden, so daß der Wirkungsgrad der von der Anordnung der Löcher betroffenen Solarzellen gegenüber den übrigen Solarzellen nicht verschlechtert ist.

Die verschiedenen Ausgestaltungen der Erfindung können einzeln oder in beliebigen Kombinationen realisiert sein. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

Die Erfindung wird nun anhand von Ausführungsbeispielen näher erläutert, wobei Bezug auf die beigefügten Zeichnungen genommen wird. Es zeigen in vereinfachter, nicht maßstäblicher Darstellung:
- Fig. 1: eine schematische Querschnittansicht zur Veranschaulichung eines beispielhaften Aufbaus eines Dünnschichtsolarmoduls gemäß vorliegender Erfindung;
- Fig. 2: eine schematische Rückseitenansicht des Dünnschichtsolarmoduls von Fig. 1 ohne Anschlußdosen;
- Fig. 3: eine schematische Rückseitenansicht des Dünnschichtsolarmoduls von Fig. 1 mit Anschlußdosen;
- Fig. 4: eine schematische Querschnittdarstellung einer ersten Variante des Dünnschichtsolarmoduls von Fig. 1 gemäß Schnittlinie A-A von Fig. 2;
- Fig. 5: eine Aufsicht im Bereich der schematischen Querschnittdarstellung von Fig. 4;
- Fig. 6: eine schematische Querschnittdarstellung einer zweiten Variante des Dünnschichtsolarmoduls von Fig. 1 gemäß Schnittlinie A-A von Fig. 2;
- Fig. 7: eine schematische Querschnittdarstellung einer dritten Variante des Dünnschichtsolarmoduls von Fig. 1 gemäß Schnittlinie A-A von Fig. 2;
- Fig. 8: eine schematische Darstellung in Aufsicht einer vierten Variante des Dünnschichtsolarmoduls von Fig. 1;
- Fig. 9: eine schematische Darstellung in Aufsicht einer fünften Variante des Dünnschichtsolarmoduls von Fig. 1.

### Ausführliche Beschreibung der Zeichnungen

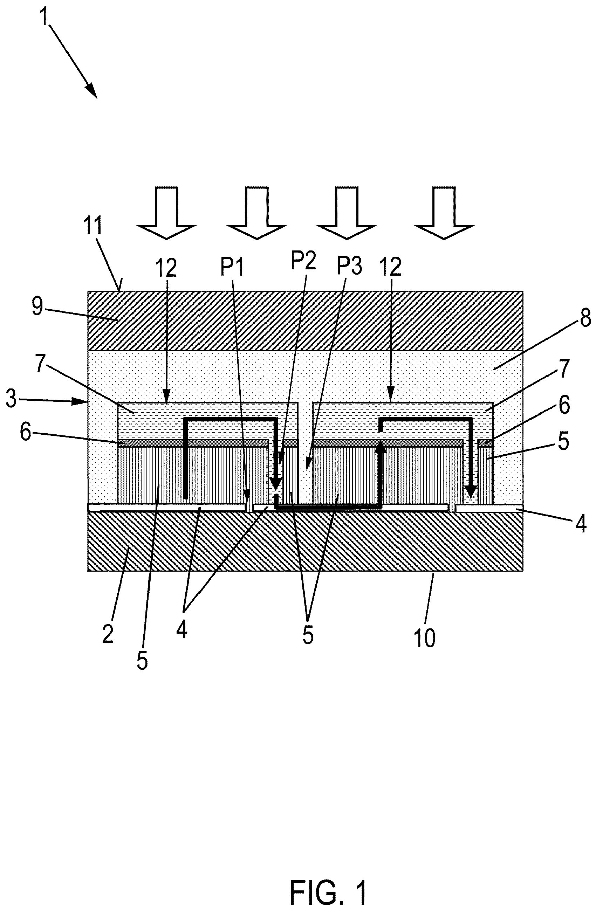

In Figur 1 ist der Aufbau eines insgesamt mit der Bezugszahl 1 bezeichneten erfindungsgemäßen Dünnschichtsolarmoduls in schematischer Weise anhand einer Querschnittansicht (Schnitt senkrecht zur Moduloberfläche) veranschaulicht. Das Dünnschichtsolarmodul 1 umfaßt eine Mehrzahl von in integrierter Form seriell miteinander verschalteten Solarzellen 12, wobei in stark vereinfachter Weise nur zwei Solarzellen 12 dargestellt sind. Es versteht sich, daß im Dünnschichtsolarmodul 1 in aller Regel eine Vielzahl von Solarzellen 12 (beispielsweise ca. 100-150) seriell verschaltet sind.

Das Dünnschichtsolarmodul 1 weist eine Verbundscheibenstruktur in Substratkonfiguration auf. Es umfaßt ein rückseitiges Trägersubstrat 2 mit einem darauf aufgebrachten Schichtenaufbau 3 aus dünnen Schichten, wobei der Schichtenaufbau 3 auf einer lichteintrittsseitigen Oberfläche des Trägersubstrats 2 angeordnet ist. Die gegenüberliegende Oberfläche des Trägersubstrats 2 bildet die Rückseite 10 des Solarmoduls 1. Das Trägersubstrat 2 ist hier beispielsweise als starre (ebene) Glasplatte mit einer relativ hohen Lichtdurchlässigkeit ausgebildet, wobei gleichermaßen andere elektrisch isolierende Materialien mit gewünschter Festigkeit und inertem Verhalten gegenüber den durchgeführten Prozeßschritten eingesetzt werden können.

Der Schichtenaufbau 3 umfaßt eine opake Rückelektrodenschicht 4, die beispielsweise aus einem lichtundurchlässigen Metall wie Molybdän (Mo) besteht und durch Aufdampfen oder magnetfeldunterstützte Kathodenzerstäubung (Sputtern) unmittelbar auf das Trägersubstrat 2 aufgebracht wurde. Die Rückelektrodenschicht 4 hat beispielsweise eine Schichtdicke im Bereich von 300 nm bis 600 nm. Auf der Rückelektrodenschicht 4 ist eine optisch (photovoltaisch) aktive Absorberschicht 5 aufgebracht, die aus einem mit Metallionen dotierten Halbleiter besteht, dessen Bandabstand in der Lage ist, einen möglichst großen Anteil des Sonnenlichts zu absorbieren. Die Absorberschicht 5 besteht aus einem p-leitenden Chalkopyrit-Halbleiter, beispielsweise eine Verbindung der Gruppe Cu(In/Ga) (S/Se)₂, insbesondere Natrium(Na)-dotiertes Cu(In/Ga) (S/Se)₂. Die Absorberschicht 5 hat eine Schichtdicke, die beispielsweise im Bereich von 1-5 µm liegt und insbesondere ca. 2 µm beträgt. Für die Herstellung der Absorberschicht 5 werden typischer Weise verschiedene Materiallagen beispielsweise durch Sputtern aufgebracht, die anschließend durch Erwärmen in einem Ofen, gegebenenfalls in einer S- und/oder Se-haltigen Atmosphäre, zum Verbindungshalbleiter thermisch umgesetzt werden (RTP = Rapid Thermal Processing). Dem Fachmann ist diese Art der Herstellung eines Verbindungshalbleiters wohlbekannt, so daß hier nicht näher darauf eingegangen werden muß. Auf die Absorberschicht 5 ist eine Pufferschicht 6 abgeschieden, die hier beispielsweise aus einer Einzellage Cadmiumsulfid (CdS) und einer Einzellage aus intrinsischem Zinkoxid (i-ZnO) besteht, was in Figur 1 nicht näher dargestellt ist. Auf die Pufferschicht 6 ist eine Frontelektrodenschicht 7 beispielsweise durch Sputtern aufgebracht. Die Frontelektrodenschicht 7 ist für Strahlung im sichtbaren Spektralbereich transparent ("Fensterelektrode"), so daß das einstrahlende Sonnenlicht nur gering geschwächt wird. Die Frontelektrodenschicht 7 basiert beispielsweise auf einem dotierten Metalloxid, beispielsweise n-leitendes Aluminium (Al)-dotiertes Zinkoxid (ZnO). Eine solche Frontelektrodenschicht 7 wird allgemein als TCO-Schicht (TCO = Transparent Conductive Oxide) bezeichnet. Die Schichtdicke der Frontelektrodenschicht 7 beträgt beispielsweise ca. 500 nm. Durch die Frontelektrodenschicht 7 wird gemeinsam mit der Pufferschicht 6 und der Absorberschicht 5 ein Heteroübergang (d.h. Abfolge von Schichten vom entgegen gesetzten Leitungstyp) gebildet.

Zum Schutz vor Umwelteinflüssen ist auf der Frontelektrodenschicht 7 eine (Kunststoff-)Klebeschicht 8 aufgebracht, die insbesondere zur Verkapselung des Schichtenaufbaus 3 dient. Durch die Klebeschicht 8 ist das Trägersubstrat 2 mit einer frontseitige Abdeckung 10 fest miteinander verbunden ("laminiert"), wobei die Klebeschicht 8 hier beispielsweise als thermoplastische Klebeschicht ausgebildet ist, die durch Erwärmen plastisch verformbar wird und beim Abkühlen die Abdeckung 9 und das Trägersubstrat 2 fest miteinander verbindet. Die Klebeschicht 8 besteht hier beispielsweise aus PVB. Die Abdeckung 9 ist für Sonnenlicht transparent und beispielsweise in Form einer starren (ebenen) Glasplatte aus extraweißem Glas mit geringem Eisengehalt ausgebildet. Die Abdeckung 9 dient zur Versiegelung und für einen mechanischen Schutz des Schichtenaufbaus 3 und bildet eine Außenfläche 11 des Solarmoduls 1. Über die Außenfläche 11 kann das Dünnschichtsolarmodul 1 Sonnenlicht aufnehmen, um eine elektrische Spannung zu erzeugen. Ein resultierender Strompfad ist in Fig. 1 durch seriell angeordnete Pfeile veranschaulicht.

Für die Formung und Serienverschaltung der Solarzellen 12 ist der Schichtenaufbau 3 unter Einsatz einer geeigneten Strukturierungstechnologie, beispielsweise Laserschreiben und/oder mechanische Abtragung, strukturiert. Zu diesem Zweck sind Abfolgen von jeweils drei Strukturierungslinien P1-P2-P3 in den Schichtenaufbau 3 eingebracht. Die Strukturierungslinien P1 unterteilen mindestens die Rückelektrodenschicht 4 in vollständig voneinander getrennte Abschnitte, wodurch die Rückelektroden der Solarzellen 12 erzeugt werden. Die Strukturierungslinien P2 unterteilen mindestens die Absorberschicht 5 in vollständig voneinander getrennte Abschnitte, wodurch die optisch aktiven Bereiche bzw. Absorber der Solarzellen 12 erzeugt werden. Die Strukturierungslinien P3 unterteilen mindestens die Frontelektrodenschicht 7 wodurch die Frontelektroden der Solarzellen 12 erzeugt werden. Über die zweiten Strukturierungslinien P2 ist jeweils die Frontelektrode einer Solarzelle 12 mit der Rückelektrode einer angrenzenden Solarzelle 12 elektrisch verbunden, wobei - wie gezeigt - die Frontelektrode die Rückelektrode vorteilhaft direkt kontaktiert.

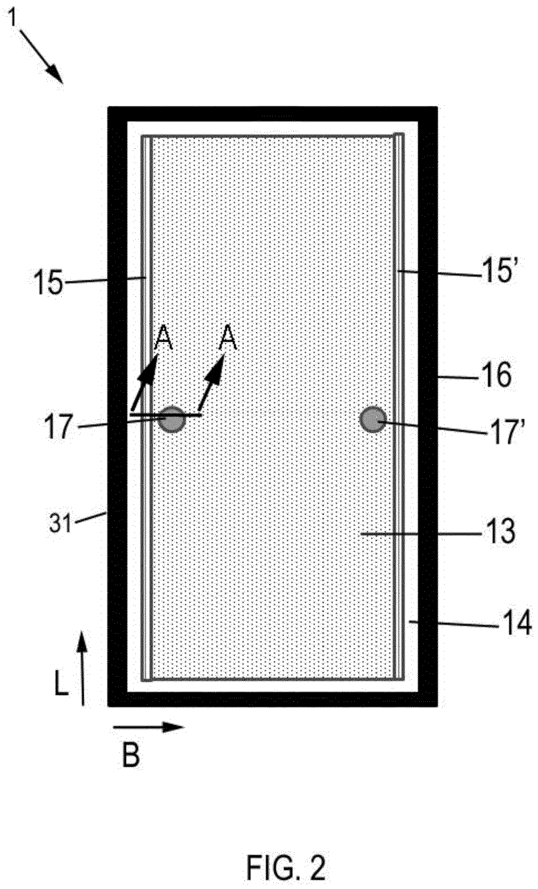

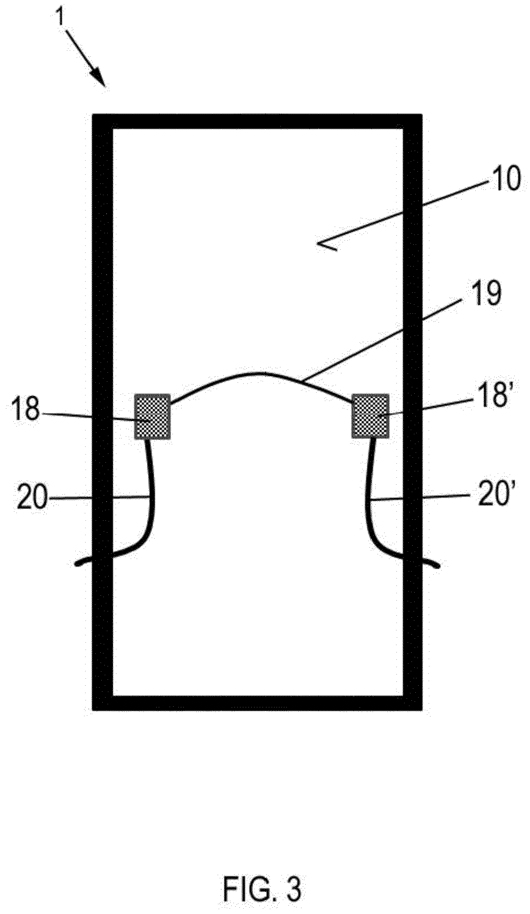

Es wird nun Bezug auf die Figuren 2 und 3 genommen, worin eine schematische Rückseitenansicht des erfindungsgemäßen Dünnschichtsolarmoduls 1 ohne Anschlußdosen (Figur 2) sowie mit Anschlußdosen (Figur 3) gezeigt ist.

Das Dünnschichtsolarmodul 1 hat in Aufsicht (bzw. in Modulebene) eine Rechteckform, mit einer längeren Abmessung bzw. Länge L und einer kürzeren Abmessung bzw. Breite B. Das Dünnschichtsolarmodul 1 umfaßt einen optisch aktiven Innenbereich 13, der ebenfalls in Rechteckform ausgebildet ist, sowie einen den Innenbereich 13 umgebenden und begrenzenden Randbereich 14. Der Innenbereich 13 wird durch die Solarzellen 12 (nicht näher dargestellt) gebildet, die entlang der Breite B des Dünnschichtsolarmoduls 1 angeordnet sind. Die Fläche des Innenbereichs 13 entspricht der Aperturfläche des Dünnschichtsolarmoduls 1. Die Solarzellen 12 sind zwischen einer ersten Leiterbahn 15 und einer zweiten Leiterbahn 15' in Serie verschaltet. Die beiden Leiterbahnen 15, 15' dienen jeweils als Stromsammelleiter (Busbars) für den von den Solarzellen 12 erzeugten Strom. Die zueinander parallelen Leiterbahnen 15, 15' sind jeweils im optisch inaktiven Randbereich 14 angeordnet und erstrecken sich geradlinig entlang der Länge L des Dünnschichtsolarmoduls 1. Die Leiterbahnen 15, 15' sind hier beispielsweise in Form von dünnen Kontaktbändern ausgebildet und bestehen aus einem elektrisch leitfähigen Material, insbesondere einem metallischen Material wie Aluminium (Al).

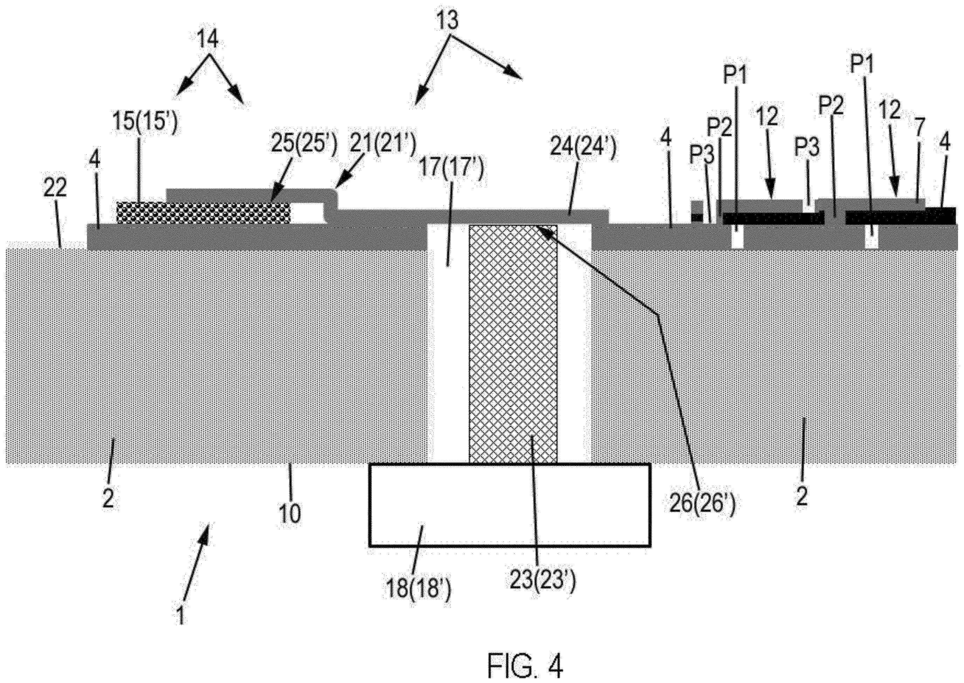

Der optisch inaktive Randbereich 14 umgibt den optisch aktiven Innenbereich 13 umlaufend (vollständig). Im Randbereich 14 ist der Schichtenaufbau 3 in einer an den Modulrand 31 angrenzenden Randentschichtungszone 22 (siehe Figur 4) entfernt. Der Randbereich 14 verfügt weiterhin über eine an den Modulrand 31 angrenzende umlaufende Randversiegelung 16, welche das Eintreten von Feuchtigkeit in das Dünnschichtsolarmodul 1 verhindert und die Langzeitstabilität verbessert.

Wie in Figur 2 erkennbar, weist das rückseitige Trägersubstrat 2 ein erstes (Durchgangs-)Loch 17 und ein zweites (Durchgangs-)Loch 17' auf, welche für die elektrische Kontaktierung der beiden Leiterbahnen 15, 15', dienen. In der Ansicht von Figur 2 befinden sich die beiden Leiterbahnen 15, 15' nicht unterhalb der Löcher 17, 17', d.h. nicht in fluchtender Verlängerung (senkrecht zum Trägersubstrat 2) der Löcher 17, 17'. Vielmehr sind die beiden Löcher 17, 17' vollständig innerhalb des Innenbereichs 13 angeordnet. In dem in Figur 2 gezeigten Beispiel sind die beiden Löcher 17, 17' jeweils soweit nach innen versetzt, daß sie einen Abstand von der zugeordneten Leiterbahn 15, 15' haben, der im Bereich von 1% bis 10% des Abstands zwischen den beiden Leiterbahnen 15, 15' liegt.

Wie in Figur 3 erkennbar, umfaßt das Dünnschichtsolarmodul 1 eine erste Anschlußdose 18 und eine zweite Anschlußdose 18'. Die beiden Anschlußdosen 18, 18' sind jeweils auf die Rückseite 10 des Trägersubstrats 2 aufgesetzt, wobei die erste Anschlußdose 18 das erste Loch 17 überdeckt und die zweite Anschlußdose 18' das zweite Loch 17' überdeckt. Hierdurch kann eine zuverlässige Abdichtung der beiden Löcher 17, 17' erreicht werden. Die erste Anschlußdose 18 verfügt über ein Anschlußkabel 20, die zweite Anschlußdose 18' entsprechend über ein Anschlußkabel 20', welche zur Verbindung des Dünnschichtsolarmoduls 1 mit einer elektrischen Last oder zum seriellen Verschalten des Dünnschichtsolarmoduls 1 mit weiteren Modulen dienen. Zwischen den beiden Anschlußdosen 18, 18' befindet sich ein Diodenkabel 19 mit einer integrierten Freilauf- bzw. Bypassdiode (nicht gezeigt), welche im normalen Betriebszustand, in dem das Dünnschichtsolarmodul 1 Strom liefert, in Sperrrichtung gepolt ist. Hierdurch wird eine Beschädigung des Dünnschichtsolarmoduls 1 bei fehlender Stromerzeugung verhindert, falls beispielsweise aufgrund einer Verschattung oder eines Moduldefekts kein Strom geliefert wird. Der von anderen Solarmodulen gelieferte Strom kann über die Freilaufdiode fließen.

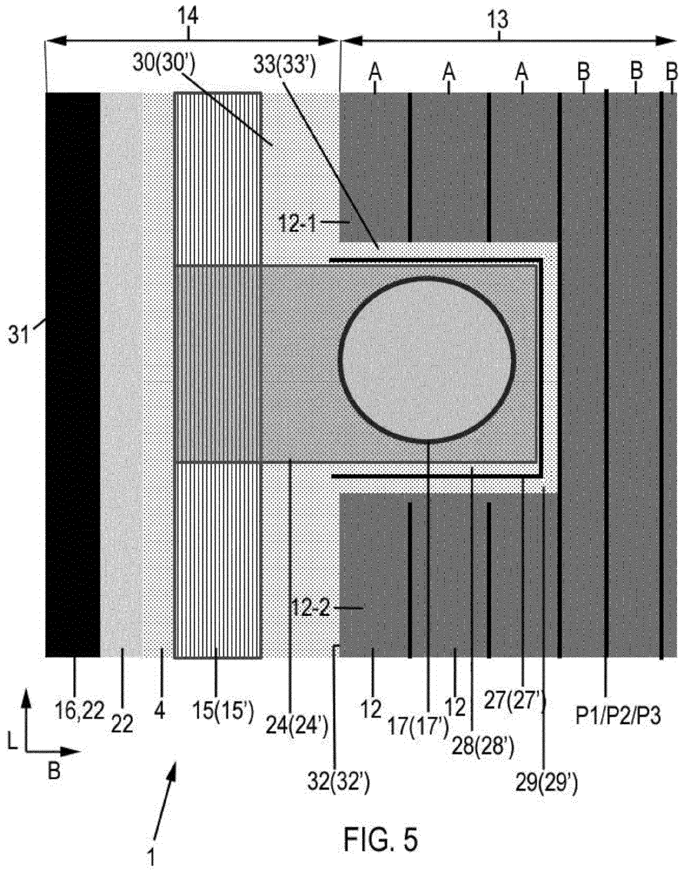

Es wird nun Bezug auf die Figuren 4 und 5 genommen, worin anhand einer schematischen Querschnittdarstellung gemäß Schnittlinie A-A von Fig. 2 sowie einer Aufsicht von oben im Bereich der Querschnittdarstellung ein Ausführungsbeispiel des Dünnschichtsolarmoduls 1 von Fig. 1 veranschaulicht ist. Es erfolgt eine Beschreibung der Komponenten, die der ersten Leiterbahn 15 zugeordnet sind, wobei die den beiden Leiterbahnen 15, 15' zugeordneten Komponenten analog aufgebaut sind. Die Bezugszeichen in Klammern entsprechen den jeweiligen Komponenten für die zweite Leiterbahn 15'.

Das Loch 17 (17') im Trägersubstrat 2 liegt vollständig im Innenbereich 13 des Dünnschichtsolarmoduls 1, so daß sich in beiden Richtungen senkrecht zur Schnittdarstellung des Lochs 17 (17') optisch aktive Bereiche der Solarzellen 12 befinden. Die Leiterbahn 15 (15') und die Randentschichtungszone 22 befinden sich im optisch inaktiven Randbereich 14. Die Leiterbahn 15 (15') ist in direkten elektrischen Kontakt mit und unmittelbar auf der Rückelektrodenschicht 4 angeordnet. In dem um die Randentschichtungszone 22 verminderten Teil des Randbereichs 14 ist der Schichtenaufbau 3 bis auf die Rückelektrodenschicht 4 entschichtet. Im Bereich der Randentschichtungszone 22 ist der Schichtenaufbau 3 komplett entschichtet. Dies kann in einfacher Weise durch an sich bekannte mechanische Entschichtungsmethoden erfolgen, worauf hier nicht nicht näher eingegangen werden muss. Im Bereich des Lochs 17 (17') befindet sich keine Rückelektrodenschicht 4, da diese auf dem Trägersubstrat 2 aufgebracht ist und bei der Formung des Lochs 17 (17') zusammen mit dem Trägersubstrat 2 entfernt wurde.

Das Dünnschichtsolarmodul 1 umfaßt ein flächiges Kontaktelement 24 (24'), welches hier in Form eines Kontaktstreifens (Kontaktbrücke) ausgebildet ist. Das Kontaktelement 24 (24') liegt der Rückelektrodenschicht 4 unmittelbar auf, überspannt das Loch 17 (17') vollständig und erstreckt sich bis zur Leiterbahn 15 (15'). Auf der Rückelektrodenschicht 4 sowie auf der lichteintrittsseitigen Oberfläche der Leiterbahn 15 (15') ist das flächige Kontaktelement 24(24') beispielsweise mittels Schweißen, Löten oder Kleben befestigt. Das flächige Kontaktelement 24 (24') umfaßt oder besteht aus einem elektrisch leitfähigen Material, insbesondere ein metallisches Material, beispielsweise Aluminium. Wie in Figur 4 erkennbar, überlappt das flächige Kontaktelement 24 (24') mit der Leiterbahn 15 (15'). Möglich wäre auch, daß das flächige Kontaktelement 24 (24') mit der gegenüberliegenden, von der Lichteintrittsseite abgewandten Oberfläche der Leiterbahn 15 (15') überlappt. In diesem Fall wird zunächst das flächige Kontaktelement 24 (24') beispielsweise mittels Schweißen, Löten oder Kleben an der Rückelektrodenschicht 4 befestigt und anschließend die Leiterbahn 15 (15') beispielsweise mittels Schweißen, Löten oder Kleben am Kontaktelement 24 (24') befestigt.

Eine elektrische Kontaktierung des flächigen Kontaktelements 24 (24')von außen erfolgt durch einen Kontaktstempel 23 (23'), der von der Anschlußdose 18 (18') absteht, das Loch 17 (17') durchsetzt, und der von der Lichteintrittsseite abgewandten Oberfläche des flächigen Kontaktelements 24 (24') unmittelbar anliegt. Der Kontaktstempel 23 (23') umfaßt oder besteht aus einem elektrisch leitfähigen Material, insbesondere ein metallisches Material. Beispielsweise ist der Kontaktstempel 23 (23') in Form einer vorspringenden (metallischen) Feder ausgebildet. Eine solche Gestaltung hat den besonderen Vorteil, daß die Anschlußdose 18 (18') in einfacher Weise automatisiert an der Rückseite 10 des Trägersubstrats 2 befestigt werden kann, wobei der Kontaktstempel 23 (23') selbsttätig in Berührungskontakt mit dem flächigen Kontaktelement 34 (24') gelangt. In der Anschlußdose 18 (18') ist der Kontaktstempel 23 (23') beispielsweise durch eine Klemm- oder Steckverbindung mit dem Anschlußkabel 20 (20') elektrisch verbunden, was in Figur 4 nicht näher dargestellt ist.

In der in Figur 4 gezeigten Variante besteht die elektrische Verbindung 21 (21') zwischen der Leiterbahn 15 (15') und dem Kontaktstempel 23 (23')aus dem flächigen Kontaktelement 24 (24'), wobei das flächige Kontaktelement 24 (24') die Leiterbahn 15 (15') an einer Abgreifstelle 25 (25') elektrisch kontaktiert (mit Berührungskontakt) und den Kontaktstempel 23 (23') an einer Anschlußstelle 26 (26') elektrisch kontaktiert (mit Berührungskontakt). In diesem Fall befindet sich die Anschlußstelle 26 (26') außerhalb der Anschlußdose 18 (18').

Es sein nun ergänzend die Aufsicht von Figur 5 betrachtet. Der Innenbereich 13 und Randbereich 14 des Dünnschichtsolarmoduls 1 sind durch Begrenzungslinien separat gekennzeichnet. Der Innenbereich 13 geht an einer Bereichsgrenze 32 (32') in den Randbereich 14 über. Der Randbereich 14 umfaßt die Randentschichtungszone 22, in der angrenzend an den Modulrand 31 die Randversiegelung 16 ausgebildet ist. In der Randentschichtungszone 22 ist der Schichtenaufbau 3 bis zur lichteintrittsseitigen Oberfläche des Trägersubstrats 2 vollständig entfernt. Zwischen der Randentschichtungszone 22 und dem Innenbereich 13 ist der Schichtenaufbau 3 bis zur Rückelektrodenschicht 4 entfernt, wodurch sich eine Entschichtungszone 30 (30') ergibt, die eine direkte elektrische Kontaktierung (mit Berührungskontakt) durch die Leiterbahn 15 (15') erlaubt.

Das Loch 17 (17') im Trägersubstrat 2 ist vollständig im Innenbereich 13 des Dünnschichtsolarmoduls 1 positioniert, wobei der Schichtenaufbau 3 im Bereich des Lochs 17 (17') bis zur Rückelektrodenschicht 4 entfernt ist. Die Entschichtungszone 30 (30') umfaßt zu diesem Zweck eine rechteckförmige Einbuchtung 33 (33') des Innenbereichs 13 an der Bereichsgrenze 32 (32'), entsprechend einem Vorsprung der Entschichtungszone 30 (30'). Dieser vorspringende Teil der Entschichtungszone 30 (30') kann vorteilhaft bei der Erzeugung der Entschichtungszone 30 (30') hergestellt werden.

Durch die Position des Lochs 17 (17') und die hierdurch bedingte Position der Einbuchtung 33 (33') des Innenbereichs 13 wird mindestens eine Solarzelle 12, hier beispielsweise drei Solarzellen 12, angeschnitten, hier beispielsweise vollständig unterteilt. Für eine leichtere Bezugnahme werden die unterteilten Solarzellen 12 mit "A", die nicht unterteilten Solarzellen 12 mit "B" bezeichnet. Jede Solarzelle A wird durch das Loch 17 (17') bzw. Einbuchtung 33 (33') des Innenbereichs 13 in zwei Teil-Zellen 12-1, 12-2 unterteilt.

Jede Solarzelle A hat eine optisch aktive (Gesamt-)Fläche, die sich als Summe der optische aktiven Flächen der beiden Teil-Zellen 12-1, 12-2 ergibt. Alle Solarzellen A haben eine gleichgroße optisch aktive (Gesamt-)Fläche. Ferner haben alle Solarzellen B eine gleichgroße optisch aktive Fläche. Wie in Figur 5 erkennbar, haben die Teil-Zellen 12-1, 12-2 der Solarzellen A eine größere Breite als die Solarzellen B, wobei deren Breite so vergrößert ist, daß die Solarzellen A und die Solarzellen B eine gleichgroße optisch aktive Fläche haben. Dies bedeutet, daß die beiden Teil-Zellen 12-1, 12-2 einer Solarzelle A in Summe eine optisch aktive Fläche haben, welche der optisch aktiven Fläche einer Solarzelle B entspricht. Hierdurch kann vorteilhafter Weise erreicht werden, daß die Solarzellen in einem zumindest annähernd gleichen Arbeitspunkt ihrer Kennlinie betrieben werden, so daß der Wirkungsgrad der Solarzellen A gegenüber den Solarzellen B nicht verschlechtert ist.

Das das Loch 17 (17') überdeckende Kontaktelement 24 (24') ist eine Kontaktbrücke mit länglicher Form, hier beispielsweise Rechteckform. Um einen elektrischen Kurzschluß der Solarzellen A durch das Kontaktelement 24 (24') zu vermeiden, ist innerhalb der Einbuchtung 33 (33') ein erster Schichtabschnitt 28 (28') der Rückelektrodenschicht 4, welchem das Kontaktelement 24 (24') anliegt, durch eine Trennlinie 27 (27') von eine zweiten Schichtabschnitt 29 (29') der Rückelektrodenschicht 4 elektrisch abgetrennt. Die Trennlinie 27 (27') umgibt das Kontaktelement 24 (24') zu diesem Zweck rahmenförmig im Innenbereich 13 bzw. innerhalb der Einbuchtung 33 (33'). Die Trennlinie 27 (27') durchtrennt die Rückelektrodenschicht 4 in voller Schichtdicke, so daß der erste Schichtabschnitt 28 (28') und der zweite Schichtabschnitt 29 (29') im Innenbereich 13 vollständig voneinander elektrisch isoliert sind. In der Modulebene weist die Trennlinie 27 (27') einen (geringen) Abstand zum Kontaktelement 24 (24') auf, könnte jedoch auch unmittelbar an das Kontaktelement 24 (24') angrenzen. Die Trennlinie 27 (27') ist jedenfalls im Innenbereich 13 ausgebildet, wodurch eine zufriedenstellende elektrische Isolierung des ersten Schichtabschnitt 28 (28') vom zweiten Schichtabschnitt 29 (29') erzielt wird. In der Ausgestaltung von Figur 5 erstreckt sich die Trennlinie 27 (27') geringfügig in den Randbereich 14 hinein, könnte sich jedoch auch bis zur Leiterbahn 15 (15') erstrecken, wodurch eine vollständige elektrische Isolierung des ersten Schichtabschnitt 28 (28') vom zweiten Schichtabschnitt 29 (29') sowohl im Innenbereich 13 als auch im Randbereich 14 erreicht wird.

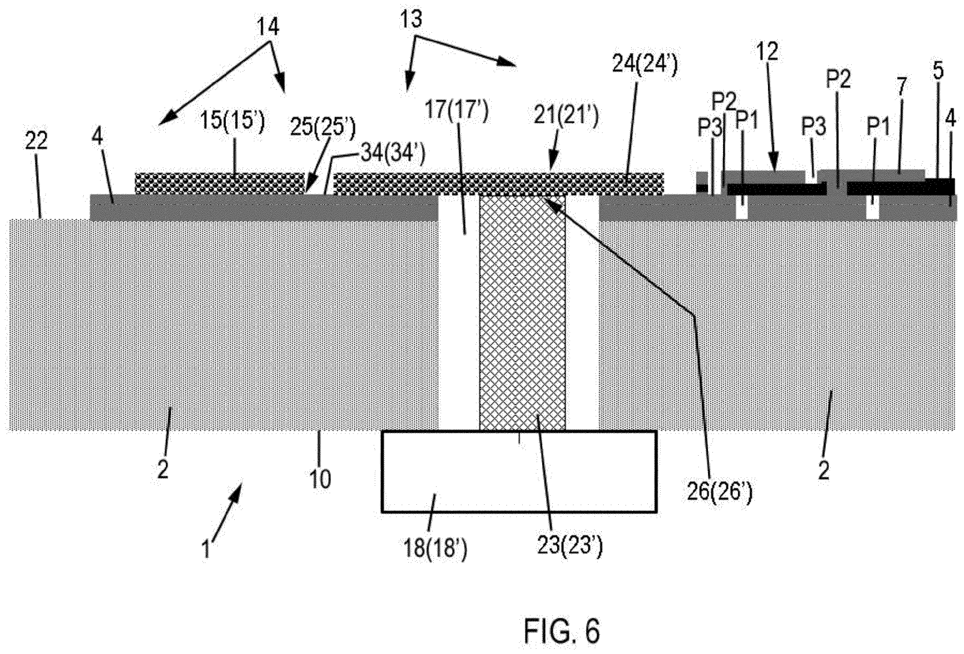

Es wird nun Bezug auf Figur 6 genommen, worin anhand einer schematischen Querschnittdarstellung gemäß Schnittlinie A-A von Fig. 2 ein weiteres Ausführungsbeispiel des Dünnschichtsolarmoduls 1 veranschaulicht ist. Um unnötige Wiederholungen zu vermeiden, werden lediglich die Unterschiede zum vorherigen Ausführungsbeispiel erläutert und ansonsten wird auf obige Ausführungen Bezug genommen.

In der in Figur 6 gezeigten Variante erstreckt sich das Kontaktelement 24 (24') im Unterschied zur vorherigen Variante nicht bis zur Leiterbahn 15 (15'), sondern weist einen Abstand zur Leiterbahn 15 (15') auf. Eine elektrische Verbindung zwischen dem Kontaktelement 24 (24') und der Leiterbahn 15 (15') erfolgt durch einen Kontaktabschnitt 34 (34') der Rückelektrodenschicht 4, der sich zwischen dem Kontaktelement 24 (24') und der Leiterbahn 15 (15') befindet. Demnach setzt sich die elektrische Verbindung 21 (21') zwischen Leiterbahn 15 (15') und Kontaktstempel 23 (23') aus dem Kontaktelement 24 (24') und dem Kontaktabschnitt 34 (34') der Rückelektrodenschicht 4 zusammen. Die Abgreifstelle 25(25') an der Leiterbahn 15 (15') ist durch jene Stelle gegeben, an der die Leiterbahn 15 (15') dem Kontaktabschnitt 34 (34') der Rückelektrodenschicht 4 in Berührungskontakt aufliegt.

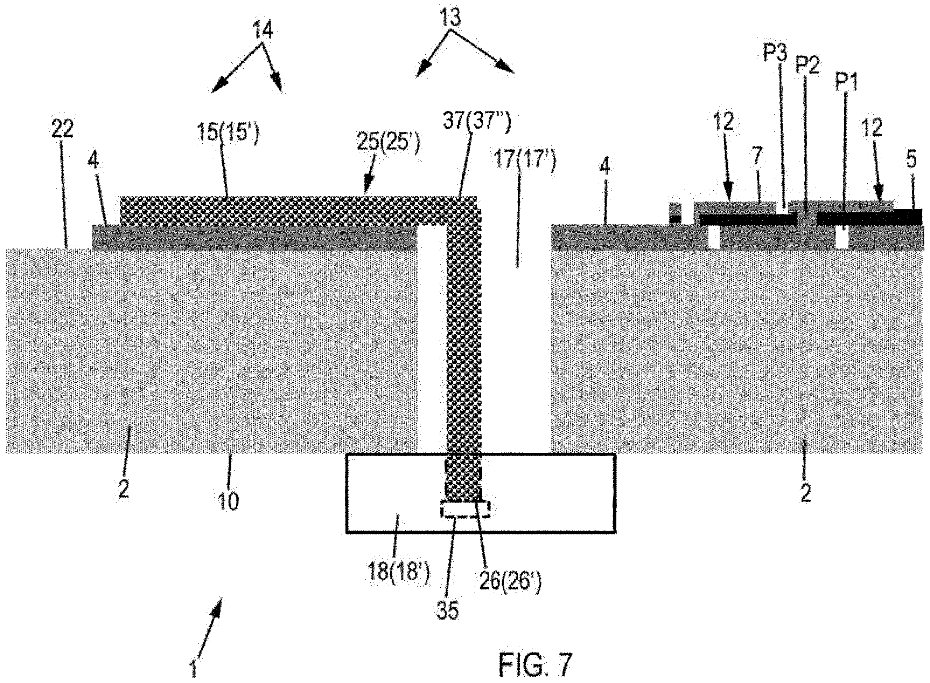

Es wird nun Bezug auf Figur 7 genommen, worin anhand einer schematischen Querschnittdarstellung gemäß Schnittlinie A-A von Fig. 2 ein weiteres Ausführungsbeispiel des erfindungsgemäßen Dünnschichtsolarmoduls 1 veranschaulicht ist. Um unnötige Wiederholungen zu vermeiden, werden lediglich die Unterschiede zu den vorherigen Ausführungsbeispielen erläutert und ansonsten wird auf obige Ausführungen Bezug genommen.

Demnach umfaßt das Dünnschichtsolarmodul 1 ein flächiges Kontaktelement 24 (24'), welches in Form eines Endabschnitts 36 (36') der Leiterbahn 15 (15') ausgebildet ist. Die Leiterbahn 15 (15') wird zu diesem Zweck beispielsweise rechtwinklig gefalzt (was in der Querschnittdarstellung von Figur 7 nicht erkennbar ist), in Richtung des Lochs 17 (17') geführt und durch das Loch 17 (17') gefädelt. Eine elektrische Kontaktierung des Endabschnitts 36 (36') erfolgt in der Anschlußdose 18 (18'), welche zu diesem Zweck ein Anschlußelement 35, beispielsweise in Form einer Klemme oder eines Crimps, aufweist. In der in Figur 7 gezeigten Variante besteht die elektrische Verbindung 21 (21') zwischen Leiterbahn 15 (15') und Anschlußdose 18 (18') aus dem Endabschnitt 36 (36') der Leiterbahn 15 (15'). Die Stelle, an der die Leiterbahn 15 (15') gefalzt ist und von der Erstreckung in Richtung der Längenabmessung L abweicht, ist die Abgreifstelle 25 (25'). Die Anschlußstelle 26 (26') ist jene Stelle, an der der Endabschnitt 36 (36') in das Anschlußelement 35 übergeht. Bei dieser Variante der Erfindung kann auf ein zusätzliches flächiges Kontaktelement, sowie einen Kontaktstempel, verzichtet werden. Wie in Figur 7 dargestellt, kann der Endabschnitt 36 (36') der Rückelektrodenschicht 4 unmittelbar aufliegen. Denkbar ist jedoch auch, daß der Schichtenaufbau 3 im Bereich des Endabschnitts 36 (36') vollständig entschichtet ist.

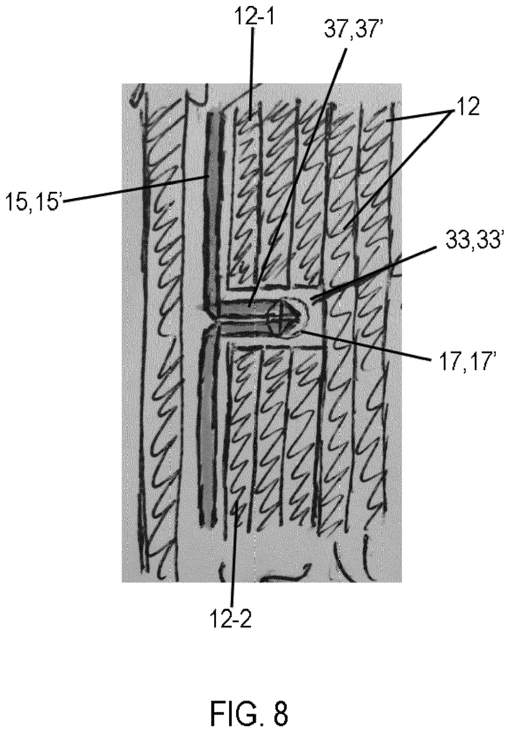

Es wird nun Bezug auf Figur 8 genommen, worin anhand einer schematischen Darstellung in Aufsicht eine vierte Variante des erfindungsgemäßen Dünnschichtsolarmoduls 1 veranschaulicht ist. Um unnötige Wiederholungen zu vermeiden, werden lediglich die Unterschiede zu den vorherigen Ausführungsbeispielen erläutert und ansonsten wird auf obige Ausführungen Bezug genommen.

Demnach umfaßt das Dünnschichtsolarmodul 1 ein flächiges Kontaktelement 24 (24'), welches in Form eines Zwischenabschnitts 37 (37') der Leiterbahn 15 (15') ausgebildet ist. Die Leiterbahn 15 (15') wird zu diesem Zweck in einem innenliegenden Bereich mehrmals beispielsweise rechtwinklig gefalzt, in Richtung des Lochs 17 (17') geführt und durch das Loch 17 (17') gefädelt. Eine elektrische Kontaktierung des Zwischenabschnitts 37 (37') erfolgt analog zur Variante von Figur 7 in der Anschlußdose 18 (18'). In der in Figur 8 gezeigten Variante besteht die elektrische Verbindung 21 (21') zwischen Leiterbahn 15 (15') und Anschlußdose 18 (18') aus dem Zwischenabschnitt 37 (37') der Leiterbahn 15 (15'). Die Stelle, an der die Leiterbahn 15 (15') erstmals gefalzt ist und von der Erstreckung in Richtung der Längenabmessung L abweicht, ist die Abgreifstelle 25 (25'). Die Anschlußstelle ist jene Stelle, an der der Zwischenabschnitt 37 (37') in das Anschlußelement 35 übergeht (in Figur 8 nicht gezeigt). Der Zwischenabschnitt 37 (37') kann der Rückelektrodenschicht 4 unmittelbar aufliegen. Denkbar ist jedoch auch, daß der Schichtenaufbau 3 im Bereich des Zwischenabschnitts 37 (37') vollständig entschichtet ist.

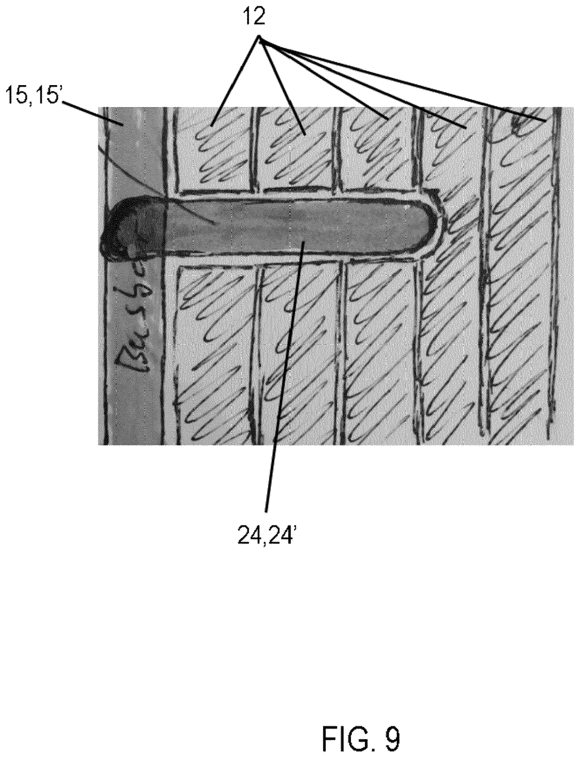

Es wird nun Bezug auf Figur 9 genommen, worin anhand einer schematischen Darstellung in Aufsicht eine fünfte Variante des erfindungsgemäßen Dünnschichtsolarmoduls 1 veranschaulicht ist. Die in Figur 9 gezeigte Variante stellt eine Abwandlung der Variante von Figur 5 dar. Um unnötige Wiederholungen zu vermeiden, werden lediglich die Unterschiede zu dieser Variante erläutert und ansonsten wird auf obige Ausführungen Bezug genommen.

Die Abwandlung von Figur 9 unterscheidet sich von Figur 5 darin, dass durch die Einbuchtung 33 (33') des Innenbereichs 13 drei Solarzellen 12 vollständig unterteilt und eine vierte Solarzelle 12 angeschnitten (d.h. nicht vollständig unterteilt) ist. Das das Loch 17 (17') überdeckende Kontaktelement 24 (24') ist eine Kontaktbrücke mit länglicher Form und abgerundeten Ecken.

Wie sich obiger Erfindungsbeschreibung ergibt, befindet sich die Position der beiden Löcher 17, 17' im Trägersubstrat 2 innerhalb des Innenbereichs 13, so daß die beiden Leiterbahnen 15, 15' weiter an den Modulrand 31 des Dünnschichtsolarmoduls 1 gelegt werden können. Zwar wird einerseits die optische aktive Fläche der Solarzellen A durch die Einbuchtungen 33, 33' vermindert, jedoch kann dieser Nachteil durch die weiter nach außen gelegten Leiterbahnen 15, 15' überkompensiert werden, so daß die Aperturfläche insgesamt vergrößert werden kann.

Dies soll anhand einer Beispielrechnung verdeutlicht werden:
Beispielsweise kann die Breite der Randversiegelung 16 von derzeit 12,5 mm auf 6 mm verschmälert werden. Das erhöht die Aperturfläche um 2* 6,5 mm * 1560 mm (= 202 cm²). Die Einbuchtungen 33, 33' des Innenbereichs 13 vermindern diesen Zugewinn wieder. Bei einem Lochdurchmesser von 4 mm und einer Breite des flächigen Kontaktelements 24, 24' von 4 mm + 3 x 3 mm = 10mm (+ 3 mm zur mechanischen/elektrischen Kontaktierung) kann man annehmen, dass die Zellfläche in der Einbuchtung 33, 33' um ca. 2 x 10 mm x 10 mm = 2 cm² reduziert wird. Es bleibt somit ein Nettogewinn von ca. 200 cm². Bei einer Aperturfläche von 9600 cm² entspricht dies einer Erhöhung der Modulleistung um 2% oder 3 Watt für ein Modul von 150 W. Die Materialkosten erhöhen sich hierbei nur marginal, wobei zusätzliche Schritte zur Strukturierung des Schichtenaufbaus 3 und gegebenenfalls zum Aufbringen des flächigen Kontaktelements 24, 24' erforderlich sind.

Wie anhand der Position der Löcher 17, 17' in Figur 1 ersichtlich, befinden sich die Abgreifstellen 25, 25' in etwa in der Mitte der beiden Leiterbahnen 15, 15'. Hierdurch können Ohm'sche Verluste in den Leiterbahnen 15, 15' verringert werden, da sich die Länge des Strompfads entlang der Leiterbahnen 15, 15' verkürzt. Dies ermöglicht eine Verminderung der Querschnittfläche der Leiterbahnen 15, 15' insbesondere durch Verringerung deren Breite, so daß die Aperturfläche in besonders vorteilhafter Weise noch weiter vergrößert werden kann.

Die Erfindung stellt ein verbessertes Solarmodul mit vergrößerter Aperturfläche zur Verfügung, das im Vergleich zu herkömmlichen Modulen gleicher Modulgröße eine höhere Stromgewinnung ermöglicht, ohne die Langzeitstabilität und Lebensdauer des Solarmoduls nachteilig zu beeinträchtigen. Die zur Herstellung des Solarmoduls erforderlichen Schritte können in einfacher Weise in bestehenden Anlagen realisiert werden.

### Bezugszeichenliste

- 1: Dünnschichtsolarmodul
- 2: Trägersubstrat
- 3: Schichtenaufbau
- 4: Rückelektrodenschicht
- 5: Absorberschicht
- 6: Pufferschicht
- 7: Frontelektrodenschicht
- 8: Klebeschicht
- 9: Abdeckung
- 10: Rückseite
- 11: Vorderseite
- 12: Solarzelle
- 12-1, 12-2: Teil-Zelle
- 13: Innenbereich
- 14: Randbereich
- 15, 15': Leiterbahn
- 16: Randversiegelung
- 17, 17': Loch
- 18, 18': Anschlußdose
- 19: Diodenkabel
- 20, 20': Anschlußkabel
- 21, 21': elektrische Verbindung
- 22: Randendschichtungszone
- 23, 23': Kontaktstempel
- 24, 24': flächiges Kontaktelement
- 25, 25': Abgreifstelle
- 26, 26': Anschlußstelle
- 27, 27': Trennlinie
- 28, 28': erster Schichtabschnitt
- 29, 29': zweiter Schichtabschnitt
- 30, 30': Entschichtungszone
- 31: Modulrand
- 32, 32': Bereichsgrenze
- 33, 33': Einbuchtung
- 34, 34': Kontaktabschnitt
- 35: Anschlußelement
- 36, 36': Endabschnitt
- 37, 37': Zwischenabschnitt

## Patentansprüche

1. Solarmodul (1) mit einem flächigen Substrat (2) und einer Mehrzahl Solarzellen (12), die zwischen zwei Leiterbahnen (15, 15') in Reihe verbunden und auf einer ersten Seite des Substrats (2) angeordnet sind, wobei die Solarzellen (12) einen optisch aktiven Innenbereich (13) bilden, der von einem optisch inaktiven Randbereich (14) umgeben ist, wobei den beiden Leiterbahnen (15, 15') jeweils zugeordnet sind:
- ein Loch (17, 17') im Substrat (2),
- eine Anschlußdose (18, 18') auf einer zweiten Seite des Substrats (2),
- eine elektrische Verbindung (21, 21') zwischen einer Abgreifstelle (25, 25') an der Leiterbahn (15, 15') und einer Anschlußstelle (26, 26') der Anschlußdose (18, 18'),
wobei das Loch (17, 17') wenigstens teilweise im Innenbereich (13) positioniert ist, derart, daß sich die Abgreifstelle (25, 25') an der Leiterbahn (15, 15') außerhalb einer fluchtenden Verlängerung des Lochs (17, 17') befindet und mindestens eine Solarzelle (12) in zwei Teil-Solarzellen (12-1, 12-2) unterteilt ist oder eine verkürzte Länge aufweist.

2. Solarmodul (1) nach Anspruch 1, welches einen auf dem Substrat (2) aufgebrachten Schichtenaufbau (3) aufweist, der eine Rückelektrodenschicht (4), eine Frontelektrodenschicht (7) und eine zwischen Rück- und Frontelektrodenschicht angeordnete Absorberschicht (5) umfaßt, wobei das Loch (17, 17') über einer Zone (30, 30') des Schichtenaufbaus (3) angeordnet ist, in der sämtliche Schichten mindestens bis zur Rückelektrodenschicht (4), insbesondere bis zur Rückelektrodenschicht (4), entfernt oder nicht aufgebracht sind.

3. Solarmodul (1) nach Anspruch 2, bei welchem die Zone (30, 30') eine Einbuchtung (33, 33') des Innenbereichs (13) umfaßt.

4. Solarmodul (1) nach einem der Ansprüche 1 bis 3, bei welchem die elektrische Verbindung (21, 21') auf der ersten Seite des Substrats (2) ein mit der Leiterbahn (15, 15') elektrisch verbundenes flächiges Kontaktelement (24, 24') aufweist, welches das Loch (17, 17') wenigstens teilweise überspannt.

5. Solarmodul (1) nach Anspruch 4, bei welchem das flächige Kontaktelement (24, 24') von einem das Loch (17, 17') durchsetzenden Kontaktstempel (23, 23') der Anschlußdose (18, 18') elektrisch kontaktiert wird.

6. Solarmodul (1) nach Anspruch 4 oder 5, in Rückbezug auf Anspruch 2 oder 3, bei welchem das flächige Kontaktelement (24, 24') einem mit der Leiterbahn (15, 15') elektrisch verbundenen Schichtabschnitt (28, 28') der Rückelektrodenschicht (4) anliegt, wobei der Schichtabschnitt (28, 28') zumindest im Innenbereich (13) von den Solarzellen (12) elektrisch isoliert ist.

7. Solarmodul (1) nach Anspruch 6, bei welchem der Schichtabschnitt (28, 28') der Rückelektrodenschicht (4) zumindest im Innenbereich (13) durch eine die Rückelektrodenschicht (4) durchtrennende Trennlinie (27, 27') von einem übrigen Schichtabschnitt (29, 29') der Rückelektrodenschicht (4) elektrisch getrennt ist.

8. Solarmodul (1) nach Anspruch 6 oder 7, bei welchem das flächige Kontaktelement (24, 24') von der Leiterbahn (15, 15') räumlich beabstandet ist.

9. Solarmodul (1) nach einem der Ansprüche 4 oder 5, bei welchem das flächige Kontaktelement (24, 24') Berührungskontakt mit der Leiterbahn (15, 15') hat, insbesondere die Leiterbahn (15, 15') überlappt.

10. Solarmodul (1) nach einem der Ansprüche 1 bis 3, bei welchem sich die Leiterbahn (15, 15') entlang einer Abmessung (L) des Substrats (2) erstreckt, wobei die elektrische Verbindung (21, 21') einen sich schräg oder quer zur Abmessung (L) des Substrats (2) erstreckenden Endabschnitt (36, 36') oder Zwischenabschnitt (37, 37') der Leiterbahn (15, 15') umfaßt, der durch das Loch (17, 17') auf die zweite Seite des Substrats (2) geführt ist.

11. Solarmodul (1) nach Anspruch 10, in Rückbezug auf Anspruch 2 oder 3, bei welchem der Endabschnitt (36, 36') oder Zwischenabschnitt (37, 37') der Leiterbahn (15, 15') einem mit der Leiterbahn (15, 15') elektrisch verbundenen Schichtabschnitt (28, 28') der Rückelektrodenschicht (4) unmittelbar anliegt, wobei der Schichtabschnitt (28, 28') zumindest im Innenbereich (13) von den Solarzellen (12) elektrisch isoliert ist.

12. Solarmodul (1) nach Anspruch 10, in Rückbezug auf Anspruch 2 oder 3, bei welchem sämtliche Schichten des Schichtenaufbaus (3) im Bereich des Endabschnitts (36, 36') oder Zwischenabschnitt (37, 37') der Leiterbahn (15, 15') entfernt oder nicht aufgebracht sind.

13. Solarmodul (1) nach einem der Ansprüche 1 bis 12, bei welchem die Abgreifstelle (25, 25') von einem Ende der Leiterbahn (15, 15') einen Abstand aufweist, der von 20% bis 50% einer Länge der Leiterbahn (15, 15') entspricht.

14. Solarmodul (1) nach einem der Ansprüche 1 bis 13, bei welchem das Loch (17, 17') im Substrat (2) einen Abstand von der zugeordneten Leiterbahn (15, 15') hat, der 1% bis 10% eines Abstands zwischen den beiden Leiterbahnen (15, 15') entspricht.

15. Solarmodul (1) nach einem der Ansprüche 1 bis 14, bei welchem alle Solarzellen (12) eine gleichgroße optisch aktive Fläche aufweisen.
